# EUROPEAN PATENT APPLICATION

(11) **EP 3 399 068 A1**
(43) Date of publication of application: **07.11.2018**
(21) Application number: 16881156.0
(22) Date of filing: 26.12.2016
(51) Int. Cl.: C23C 14/24, C23C 14/26

(54) **HEATER DEVICE FOR HEATING CRUCIBLE, OPERATION METHOD THEREFOR AND CRUCIBLE FOR CONTAINING AND HEATING MATERIAL TO BE EVAPORATED OR SUBLIMATED**

(30) Priority: 31.12.2015 CN 201511026879
(71) Applicant: China Triumpf International Engineering Co. Ltd., Shanghai 200063 (CN); CTF Solar GmbH, 01109 Dresden (DE)
(72) Inventor: FU, Ganhua, 01109 Dresden (DE); SIEPCHEN, Bastian, 01109 Dresden (DE); HEIMFARTH, Jan Peter, 01109 Dresden (DE); SHIN, Ken K., 01109 Dresden (DE); DELAHOY, Alan E., 01109 Dresden (DE); XIA, Shengjiang, 01109 Dresden (DE); RAU, Stefan, 01109 Dresden (DE); PENG, Shou, Shanghai 200063 (CN)
(74) Representative: Kailuweit & Uhlemann Patentanwälte Partnerschaft mbB
(86) International application number: PCT/CN2016/112165
(87) International publication number: WO 2017/114367

(57) **Abstract**

The present invention provides a heater device (200) for heating a crucible (10, 100) and a method for operating the same, a crucible (10, 100) for heating a material to be evaporated or sublimated. The crucible (10, 100) has a bottom surface (11, 110) and at least one side surface (13, 131). The heater device (200) comprises at least one resistance bottom heater (220, 220a, 220b) for the bottom surface (11, 110) of the crucible (10, 100) and at least one resistance side heater (210) for each side surface (13, 131) of the crucible (10, 100). At least one heater (220, 220a, 220b, 210) of the heaters (220, 220a, 220b, 210) comprises different heating sections adapted to introduce different amounts of heat into different portions of each surface of the crucible (10, 100). The crucible (10, 100) comprises at least one groove recess (140), the at least one groove recess (140) being adapted to receive a material to be evaporated or sublimated; at least one crucible wall (150, 150a-c), the at least one crucible wall (150, 150a-c) extending from a second surface (120) of the crucible (10, 100) to the inside of the groove recess (140); and at least one bottom recess (160), the at least one bottom recess (160) being formed inside the crucible wall (150, 150a-c). The bottom recess (160) is adapted to receive a wall heater.

## Description

### Cross References to Related Applications

This application claims the benefit of priority to Chinese Patent Application No. CN201511026879.8, entitled "Semiconductor Device and Preparation Method Thereof', filed with SIPO on December 31, 2015, the contents of which are incorporated herein by reference in its entirety.

### Field of Invention

The present invention relates to a heater device for heating a crucible for containing or heating a material to be evaporated or sublimated, relates to a method for operating the heater device, a crucible for containing and heating a material to be evaporated or sublimated, and relates to a system for evaporating or sublimating a material, wherein the system comprises the crucible and the heater device specially for heating the crucible. For example, the heater device, the crucible and the system are particularly adapted to deposit a evaporated or sublimated material on a large surface of a substrate used in solar cell production.

### Background

A technology for depositing a material on a substrate is physical vapor deposition, wherein vapor of the material to be deposited is produced from a material resource by means of high-temperature (temperature higher than boiling temperature or sublimation temperature of the material) evaporation or sublimation. Evaporated material particles move towards the substrate and are finally deposited onto the surface of the substrate. Particularly, during batch production or treatment of a large substrate, e.g., if the substrate crosses over a crucible in a direction perpendicular to a first direction, the crucible containing the material to be deposited, i.e., the material source, at least has a large size in the first direction. Usually, the crucible is heated through a heating lamp, an RF coil or a resistance heater which is placed on an outer surface of the crucible or is disposed distant to the crucible. A heater or heating element and the crucible are usually thermally decoupled, and heat can be transferred by means of radiation or gas convection. As an example, US8,557,045 B2 discloses a crucible or a heat trough formed by graphite blocks and having a recess or opening for holding containing a material to be evaporated or sublimated, wherein the crucible is heated through a heating lamp, resistor or induction heater placed in a shell, and the shell also contains bottom portion and most portions of side walls of the crucible. In US 2014/0109829 A1, an evaporation unit comprises a crucible and a heater frame which is spaced apart from the crucible and is disposed to surround a lateral surface or side surface and a bottom surface of the crucible. Heaters for heating the crucible are disposed on an inner surface of the heater frame opposite to the crucible.

Particularly, in regard to a large crucible having one large opening or groove recess for holding a material to be evaporated, temperature inside of the material to be evaporated may change within a large range in length and width of the crucible and height of the material to be evaporated as well. This effect is caused by poor heat conductivity of the material to be evaporated, and this material, for example, may be CdTe or CDS in solar cell production. These temperature differences possibly cause non-uniform deposition of the material on the substrate. Besides, so-called "caking" possibly occurs, wherein the material to be evaporated firstly is evaporated or sublimated in an area adjoining the side surface of the crucible, such that the remaining portion of the material to be evaporated forms a block or cake in the middle of the groove recess and is out of contact with the side surface. This caking is then heated only by heat transferred from the bottom surface of the crucible, and this causes less heat transfer and reduced material deposition rate.

Usually, heaters surrounding one or more side surfaces and a bottom surface form an integral single-piece element and this single-piece element does not provide a possibility of controlling temperature of different areas of the crucible in different ways. In order to minimize the temperature difference, an array of holes are formed in a heat sink of US 8,557,045B2, wherein each hole which contains a material to be evaporated has a small diameter and is surrounded by the material of the crucible. US 2014/0109829 A1) describes a plurality of lateral reflectors, the lateral reflectors are disposed on each side surface of the heater frame, i.e., are disposed on side surfaces of the crucible. Each lateral reflector comprises a first reflector having a first opening and a second reflector having a second opening, wherein the second reflector can move laterally, such that an overlapping rate of the first opening and the second opening is changeable. Depending on the overlapping rate, heat is lost from the heaters and thus the temperature of the crucible can be controlled by changing the lateral reflectors corresponding to specific areas of the crucible.

However, these solutions have different disadvantages and are complex solutions to solve the temperature difference. Besides, caking cannot be prevented.

In regard to the heaters which form an integral single-piece element, a further problem is caused by change of heat transferred from the crucible to the deposition material and then to the substrate thereon through radiation or gas convection. When the crucible is almost fully filled with the material to be evaporated, the crucible transfers a first heat having a first amount and a first lateral distribution. If the height of the material to be evaporated in the crucible is reduced with time, the crucible will transfer heat, which at least has a different lateral distribution from that of the first heat, to the substrate. Therefore, the substrate is heated with time through the crucible in different ways, and thereby changing the quality and/or quantity of the material deposited on the substrate.

### Summary

Therefore, the purpose of the present invention is to provide a heater device, a method for operating the heater device and a crucible with improved temperature uniformity and improved substrate temperature uniformity in a material to be evaporated over time.

In order to realize this purpose, the present invention provides a heater device for heating a crucible according to claim 1, a method for operating the heater device according to claim 9, a crucible for containing and heating a material to be evaporated or sublimated according to claim 11, and a system for evaporating or sublimating a material according to claim 17. Embodiments are included in dependent claims.

According to a first aspect of the present invention, the heater device is adapted to heat a crucible having a bottom surface and at least one side surface. The crucible is adapted to contain a material to be evaporated or sublimated and thus has a groove recess formed in a top surface of the crucible. The groove recess is adapted to receive a material to be evaporated, and the top surface of the crucible is opposite to the bottom surface of the crucible. The heater device comprises at least one resistance bottom heater for the bottom surface of the crucible and at least one resistance side heater for each side surface of the crucible; at least one heater of the heaters comprises different heating sections and the different sections are adapted to introduce different amounts of heat energy with different amounts into different portions of each surface of the crucible. In other words, the different heating sections of the at least one heater produces different amounts of heat energy with different amount per unit area of a surface corresponding to the heater. For example, if the heater is a side heater, a first heating section disposed closer to the top surface of the crucible than a second heating section introduces a greater amount of heat per unit area into the side surface of the crucible than the second heating section. In another example, the first heating section of the side heater (the first heating section is disposed closer to a corner edge of the crucible than the second heating section of the same side heater) introduces a greater amount of heat per unit area into the side surface of the crucible than the second heating section. An edge of a corner of the crucible is an edge of the crucible at which two side surfaces of the crucible adjoin each other. Different heating sections thus can balance temperature differences in the material to be evaporated in the crucible or contained in the groove recess, wherein the temperature differences are possibly caused by heat loss from the crucible or the material to be evaporated to a surrounding environment, or are possibly caused by the structure of the crucible. Thus, uniformity of heat transferred to a substrate can also be improved and thus lateral distribution of substrate temperature is improved. Besides, the side heaters, the bottom heater and different heating sections of specific heaters can be controlled with time, such that the amount of heat transferred from the crucible to the substrate and/or lateral distribution are substantially unrelated to time and the height of the material to be evaporated contained in the crucible.

At least one bottom heater is adapted to be disposed in a bottom recess formed as an opening in a bottom surface of the crucible, or is adapted to be disposed on the bottom surface of the crucible or be disposed distant to the bottom surface. At least one side heater is adapted to be disposed in a side recess formed in a side wall of the crucible, or is adapted to be disposed on a side surface of the crucible or be disposed distant to the side surface. The side wall extends from the top surface of the crucible to the bottom surface of the crucible and connects the top surface and the bottom surface. The side recess is formed in a hollow space in the side wall of the crucible, such that the opening of the hollow space adjoins the bottom surface of the crucible. However, the side recess may also be formed as an opening in the side surface of the crucible such that the side wall is open to the side. The side surface is a surface of the side wall opposite to the surface of the side wall close to the groove recess for receiving the material to be evaporated.

The heater device is adapted to the shape of the crucible in shape, design and particularly number of heaters. As long as the crucible has a top surface, a bottom surface and at least one side surface, the shape of the crucible is not limited, i.e., the crucible may be, for example, a straight cylinder or an oblique cylinder having a circular or elliptical top surface and/or bottom surface, or may be any type of straight prisms or oblique prisms such as cuboids, or any other types of bodies.

According to a first embodiment 1 of the heater device, different heating sections are formed resistance heating elements in different assembling densities per unit area. As described above, one heater usually is formed as an integral single-piece element, i.e., a long electric conductor laid in a zigzag pattern, i.e., the conductor has a plurality of parallel and straight portions, wherein corresponding end portions of two adjacent portions of these parallel portions are connected through bending portions of the conductor. The conductor according to the prior art has a constant assembling density in separate parallel portions in the entire extension portion of the conductor, i.e., a distance of two adjacent portions of parallel portions of the conductor is equal for all parallel portions. Contrarily, the heater device in embodiment 1 of the present invention has different heating sections, and the heating sections are characterized in that the assembling densities of the parallel portions of the conductor are different. However, heating elements may also be separate parallel conductors, wherein all end portions, disposed on one and the same side of the heating elements, of separate heating elements are connected through the common conductor, i.e., the heater may be formed like a ladder, wherein the separate heating elements are ladder spokes and are disposed at a changing distance to one another. The heating elements in embodiment 1 may be disposed in the side heater of the crucible, such that the heating elements vertically extend or the heating elements horizontally extend.

According to a second embodiment 2 of the heater device, different heating sections are formed by different resistance heating elements adapted to produce different amounts of heat through an amount of power applied from a power source to the heater, i.e., by different heating elements. For example, heating elements of different heating sections of the heater are formed by different materials having different resistivities, or are formed according to different cross sections of current flow. Besides, each heating element may comprise an additional resistance part, the resistance part does not make a contribution to production of heat energy, but causes the decrease of power applied to the remaining portions of the heating element, wherein the additional resistance parts are different for heating elements at different heating sections. Therefore, the remaining portions of the heating elements may be the same for all heating elements. However, since the additional resistance parts are serially connected with the remaining portions of the separate heating elements, power which can be converted into the remaining portions of the separate heating elements may be different for different heating sections.

According to a third embodiment, the heater comprises different portions adapted to receive different amounts of power applied from different power sources. Specific portions are connected to specific power sources and form specific heating sections. Therefore, one heater corresponding to one surface of the crucible comprises at least two different portions, and the portions are mutually and electrically insulated and are connected to different power sources.

According to a specific design of the heater device, the heating sections of the side heater are disposed and formed such that the heat energy introduced into the first portion of the corresponding side surface of the crucible is higher than the heat energy introduced into the second portion of the same side surface. The first portion has a greater distance to the bottom surface of the crucible greater than the second portion. Therefore, more heat energy is introduced into the first portion of the side surface disposed close to the top surface of the crucible than the second portion, and the heat loss and temperature decrease close to the top surface of crucible can be reduced.

Besides, the heating sections of the side heater are disposed and formed such that the heat energy introduced into the third portion of the side surface of the crucible is higher than the heat energy introduced into the second portion of the same side surface. The third portion has a smaller distance to the bottom surface of the crucible smaller than the second portion. Therefore, more heat energy is introduced into the third portion of the side surface disposed close to the bottom surface of the crucible than the second portion, and better temperature uniformity in the material to be evaporated close to the bottom edge of the crucible can be realized. In this specific design, the side heater comprises three heating sections which are horizontally overlapped with each other, wherein the first heating section disposed close to the top surface of the crucible produces more heat per unit area than the second heating section disposed at the middle portion of the side surface, and the third heating section disposed close to the bottom surface of the crucible produces more heat per unit area than the second heating section.

According to a further specific design of the heater device, the heater device comprises at least three side heaters, and each of the side heaters corresponds to a specific side surface of the crucible. At least one of these side heaters comprises a heating section, and the heating section is disposed and formed such that the heat energy introduced into a fourth portion of the corresponding side surface of the crucible is higher than the heat energy introduced into a fifth portion of the same side surface. The fourth portion has a distance to planes of specific adjacent side surfaces of the crucible smaller than the fifth portion. Therefore, more heat is introduced into the fourth portion of the side surface disposed close to adjacent side surfaces of the crucible than the fifth portion, and better temperature uniformity in the material to be evaporated close to the side edge of the crucible can be realized.

In a specific design of the heater device, the heater device is adapted to a cuboidal crucible having two long side surfaces and two short side surfaces. Each of the heaters is formed as a long electric conductor, and the electric conductor has a higher resistivity and is disposed in a zigzag pattern. Two corner heaters and at least one middle heater are disposed on each long side surface of the crucible. The two corner heaters are disposed at an edge of the corresponding side surface and the at least one middle heater is disposed in the middle of the two corner heaters. A conductor of the middle heater is disposed to zigzag and horizontally extend and conductors of the corner heaters are disposed to zigzag and vertically extend. A conductor of the at least one bottom heater is disposed to zigzag extend along a long extension portion of the crucible. Each heater has different heating sections formed by conductors in different assembling densities. For the corner heaters and the bottom heater, the heating sections having higher assembling densities are formed at portions of each heater having a smaller distance to the edge of each surface of the crucible than portions of each heater having a greater distance to each edge of the surface. For the middle heaters, the heating sections having higher assembling densities are formed at portions of each heater having a smaller distance to a top surface of the crucible or the bottom surface of the crucible than other portions of each middle heater. In this specific design, the advantages of the above-mentioned designs are combined, and very good temperature uniformity in the material to be evaporated is provided.

A method for operating the heater device comprising at least one heater having different heating sections provided by the present invention comprises: connecting at least two different heating sections of at least one bottom heater of the at least one bottom heater and one and/or specific heater of the at least one side heater to different power sources, and applying different amounts of power to the at least two different heating sections. Therefore, the introduced heat which is produced by different heaters and/or different heating sections can be respectively controlled and can adapt to specific crucibles, materials to be evaporated and requirements of evaporation processes in an optimum way. Besides, in this way, the lateral uniformity of substrate temperature can also be improved. For example, the corner heaters disposed close to the side and corner portions of the crucible are supplied with higher power than the middle heater disposed in the middle portion of the side surface of the crucible. In the same way, as an example, the bottom heater may also be supplied with higher power than one of the side heaters.

In one specific embodiment of the method, the power applied to the at least two different heating sections and/or the power applied to at least one of the at least one bottom heater and one of the at least one side heater change with time in different ways. Therefore, the introduced heat which is produced by different heating sections or different heaters can be adapted to decrease the amount of the material to be evaporated in the crucible or adapted to other requirements of the evaporation process. For example, when the amount of the material to be evaporated is reduced, power which is less than the power applied to the bottom heater may be applied to the side heater. Besides, when the crucible is almost fully filled with the material to be evaporated, the power applied to the bottom heater may increase with time. Therefore, the heat to be introduced into the material to be evaporated can be controlled, such that the amount of the material to be evaporated does not change with time. Besides, the heat transferred from the crucible to the substrate can be kept to be almost constant at least according to the lateral distribution in the operating life of the crucible. The operating life of the crucible is time from the first use of the crucible filled with the material to be evaporated to the last use of the crucible filled with the same material, wherein the amount of the material is continuously reduced.

According to a second aspect of the present invention, the present invention provides a crucible for heating a material to be evaporated or sublimated. The crucible comprises at least one groove recess, and the at least one groove recess is adapted to receive the material to be evaporated or sublimated. The groove recess is formed in a first surface of the crucible and has at least one first portion and at least two second portions. The first portion extends to a first depth measured from the first surface of the crucible and has a bottom surface, and the bottom surface is formed at a distance to the first depth of the first surface of the crucible. The second portions extend to a second depth greater than the first depth, and the second depth is measured from the first surface of the crucible. The crucible further comprises at least one crucible wall, the crucible wall extends from a second surface of the crucible to a bottom surface of one of the at least one first portion of the groove recess. The second surface of the crucible is opposite to the first surface of the crucible. The crucible wall is made of a material of the crucible. The crucible wall adjoins and laterally separates the two second portions of the groove recess, wherein the two second portions adjoin the first portion of the groove recess. Besides, the crucible comprises at least one bottom recess formed inside the crucible wall. The bottom recess has an opening adjoining the second surface of the crucible and a third depth, greater than the first depth and smaller than the second depth, extending from the second surface of the crucible. The third depth is also measured from the first surface of the crucible, i.e., the crucible has a crucible wall which extends like a finger from the bottom surface of the crucible to the groove recess. The bottom recess in the crucible wall is adapted to receive a heater for heating the crucible. Therefore, the temperature uniformly in the material to be evaporated is improved, and thus a film can be more stably and uniformly deposited on the substrate.

In one specific embodiment, the crucible wall is spaced apart from all side walls of the crucible through the second portions of the groove recess, i.e., the crucible wall does not adjoin any side surface of the crucible.

In another embodiment, the crucible comprises more than one crucible walls, such as two or three or more crucible walls. At least two crucible walls extend in parallel with each other. At least one bottom recess is formed in each crucible wall.

In one further embodiment, the crucible comprises more than one crucible walls, wherein at least two crucible walls are intersected with each other. Besides, at least one bottom recess is formed in each crucible wall. Under this situation, bottom recesses of different crucible walls may adjoin one another or may be separated from one another through the material of the crucible wall.

In another embodiment, the crucible comprises more than one crucible walls, wherein at least two crucible walls extend in directions which are orthogonal with each other. However, different crucible walls are not intersected with each other but are spaced apart from each other through one of the at least two second portions of the groove recess.

In this way, the design of the crucible walls can be adapted to the crucible, the material to be evaporated and the requirements of the evaporation process.

The above-mentioned crucible is disposed in a system for evaporating or sublimating a material, and the system further comprises a heater device for heating the crucible. The heater device comprises at least one wall heater disposed in at least one bottom recess in the crucible wall.

The heater device may further comprise the heater device according to the first aspect of the present invention.

Besides, according to one specific embodiment of the system for evaporating or sublimating the material, the at least one wall heater comprises different heating sections, and the heating sections are adapted to introduce different amounts of heat into different portions of the crucible wall in which the wall heater is disposed. Thus, the wall heater may also be designed according to the first aspect of the present invention.

### Brief Description of the Drawings

The drawings are included to provide further understanding about the embodiments of the present invention, and are incorporated into and constitute a part of the description. The drawings illustrate the embodiments of the present invention, which are used together with the description for explaining the principle. Other embodiments of the present invention and many advantages of expected advantages can be easily aware since they can be better understood with reference to the detailed description below. Components in the drawings are not certainly drawn in scale relative to one another. Similar reference signs indicate corresponding similar parts.
FIG. 1 illustrates a cross sectional view of a crucible having a heater device according to an embodiment of the present invention.
FIG. 2A to FIG. 2C illustrate examples of heaters having different heating sections in different assembling densities.
FIG. 3A and FIG. 3B illustrate examples of heaters having different heating sections, wherein the heating sections are adapted to produce different amounts of heat in response to an amount of power applied to the heaters.
FIG. 4 illustrates an example of a heater having different portions adapted to receive different amounts of applied power.
FIG. 5 illustrates a view of portions of a heater device according to one specific design of the heater device.
FIG. 6 illustrates a cross sectional view of a crucible according to one embodiment of the present invention.
FIG. 7A to FIG. 7D illustrate planar views of crucible walls of a crucible according to exemplary designs of the present invention.

### Detailed Description of the Preferred Embodiments

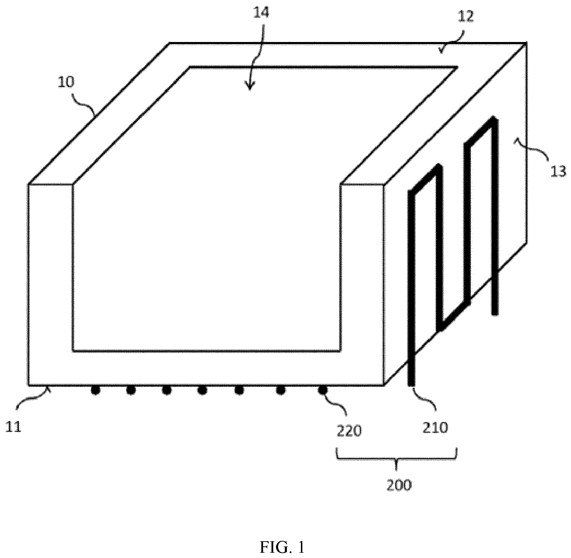

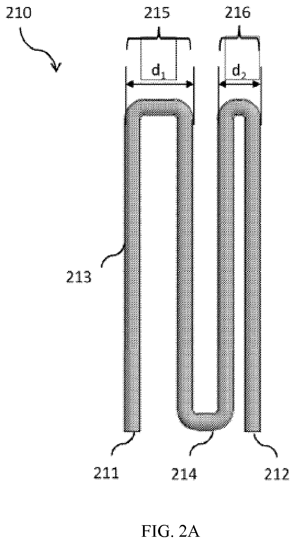

FIG. 1 illustrates a perspective view of a cross sectional view of a crucible 10 having a heater device 200 according to one exemplary embodiment of the present invention. The crucible 10 is a cuboid made of graphite or any other suitable materials and has six surfaces, i.e., a bottom surface 11, a top surface 12 and four side surfaces. In this view, only one side surface 13 of the crucible can be seen from the crucible. A groove recess 14 is formed in the top surface 12 and the groove recess 14 is adapted to contain a material to be evaporated or sublimated. The groove recess 14 has an opening in the top surface 12 and may have any suitable shape and any suitable size. Besides, the crucible 10 may have more than one groove recesses 14. The heater device 200 comprises at least one side heater 210 and at least one bottom heater 220, and the bottom heater 220 is disposed in the bottom surface of the crucible 10. In FIG. 1, only the side heater 210 disposed on the side surface 13 of the crucible 10 can be seen only. The heater is a resistance heater comprising an electric conductor, heater and the electric conductor produces heat when current flows. The electric conductor comprises a heating element and the heating element is disposed in a specific way. At least one of the heaters such as the side heater 210 or the bottom heater 220 comprises different heating sections. The heating sections will be explained with reference to FIG. 2A to FIG. 4 together with the explanation of term "heating element". In FIG. 1, only the bottom heater 220 can be seen in the cross section of the heating element passing through the conductor.

FIG. 2A to FIG. 2C illustrate schematic views of examples of side heaters 210 comprising different heating sections having different assembling densities. FIG. 2A illustrates a first example, wherein the side heater 210 is formed by a long and continuous electric conductor, and the electric conductor has a suitable diameter on the cross section and is laid in a zigzag pattern. The electric conductor has a first end portion 211 at a first end of the conductor and a second end portion 212 at a second end of the conductor. The first end portion 211 and the second end portion 212 are adapted to connect with to a power source and used for applying power to the conductor. End portions 211 and 212 both are disposed at a bottom of the side heater 210. The side heater 210 has a plurality of parallel straight heating elements 213 which are parallel and straight, and the heating elements 213 vertically extend, wherein adjacent heating elements of the heating elements 213 are connected through bending portions 214. In the first heating section 215 of the side heater 210, adjacent heating elements 213 are disposed with a distance d1 to each other. In the second heating section 216, adjacent heating elements 213 are disposed with a distance d₂ to each other, wherein d2 is smaller than d1. Therefore, the assembling density of the heating elements 213 in the second heating section 216 is greater than that in the first heating section 215. As a result, even though the electric conductors of the heating sections 215, 216 both are formed by the same cross section and are formed by the same material, the second heating section 216 is adapted to introduce heat energy with an amount per unit area greater than the first heating section 215 into the corresponding side surface.

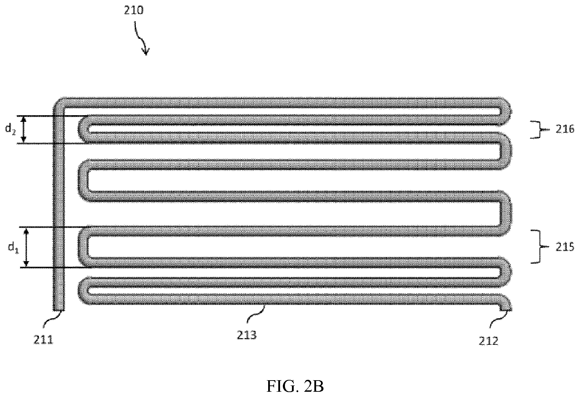

FIG. 2B illustrates a second example of the side heater 210 comprising different sections 215, 216 having different assembling densities of heating elements. A difference from the first example only lies in that the heating elements 213 extend horizontally instead of vertically. Electric connection from the side heater 210, i.e., the end portions 211, 212 of the conductor to the power source for applying power to the side heater 210 is disposed again at the bottom of the side heater 210 in the same way.

In the first example of the side heater 210, it is allowed to introduce heat energy of different amounts into the vertical portion of the side surface, while in the second example of the side heater 210, it is allowed to introduce heat energy of different amounts into the horizontal portion of the side surface. Therefore, the side heater 210 may be formed according to the requirement on the introduction of heat to the side surface of the crucible.

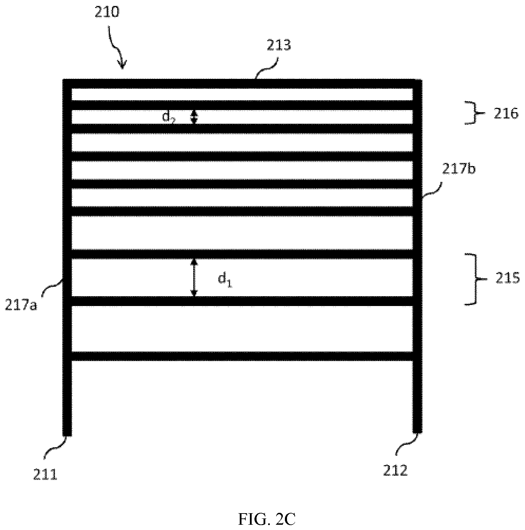

FIG. 2C illustrates a third example of the side heater 210 comprising different sections 215, 216 having different assembling densities of heating elements 213. In this situation, the side heater 210 is not formed as a long and continuous conductor but is formed as a plurality of separate heating elements 213, and the heating elements 213 are disposed in parallel and extend horizontally extend. Each heating element 213 a first end formed on a first side of the heating element 213 and a second end formed on an opposite second side of the heating element 213. The first ends of all heating elements 213 are connected with one another through a first side conductor 217a which vertically extends on the first side of the heating elements 213. The second ends of all heating elements 213 are connected with one another through a second side conductor 217b which vertically extends on the second side of the heating elements 213. Therefore, in the third example, the side heater 210 is formed similar to a ladder, wherein the heating elements 213 are ladder spokes. An end portion of the first side conductor 217a forms a first end portion 211 of the side heater 210 and an end portion of the second side conductor 217b forms a second end portion 212 of the side heater 210. Besides, the side heater 210 comprises a first heating section 215 and a second heating section 216, the heating elements 213 in the first heating section 215 are disposed with a first distance d1 to one another, and the heating elements 213 in the second heating section 216 are disposed with a second distance d₂ to one another. The second distance d2 is smaller than the first distance d1. As a result, in the third example of the side heater 210, the heat energy can be introduced into the side surface of the crucible in a way similar to the way in the second example of the side heater 210.

Some sizes of the heater will be given below, and the heater may be the side heater for the long side of the crucible, the side heater for the short side of the crucible, or the bottom heater. The heating element 213 may have any length along the extension direction thereof, e.g., the heating element 213 has a length in the range of 100mm-400mm, wherein the greater length is applicable to the heating elements 213 which extending horizontally. For the heating elements 213 which extending vertically, the length is preferably within a range of 200mm-300mm, and more preferably within a range of 220mm-240mm. Besides, different heating elements may have different lengths or may be shifted with one another in a length direction. A distance between the first end portion 211 and the second end portion 212 measured in the horizontal direction may be within a range of 60mm-600mm, and preferably within a range of 100mm-500mm. Distances between two adjacent heating elements 213, i.e., d₁ and d₂ in FIG. 2A to FIG. 2C, may change between in the range of 15mm -40mm for example. Therefore, in heating sections having high assembling densities of heating elements, the heating elements have a small mutual distance in the range of about 15mm-20mm, while in heating sections having low assembling densities of heating elements, the heating elements have a greater mutual distance in the range of 35mm-40mm. Besides, each heater may have more than two different heating sections, wherein heating elements in two or more than two heating sections may be disposed with the same mutual distance. Besides, heating sections having different assembling densities of heating elements may be disposed in the heater in the same way, i.e., symmetric relative to a centerline passing through the heater, or asymmetric. Besides, the heater may have different heating sections with heating elements which extend differently along the heating sections, i.e., in the first heating section, the heating elements may vertically extend, while in the second heating section, the heating elements may horizontally extend. Preferably, all heating elements are respectively located in planes in parallel with planes of corresponding side surfaces or a plane of the bottom surface. The conductor of the heater has a cross section diameter within 5mm-15mm, and preferably about 10mm.

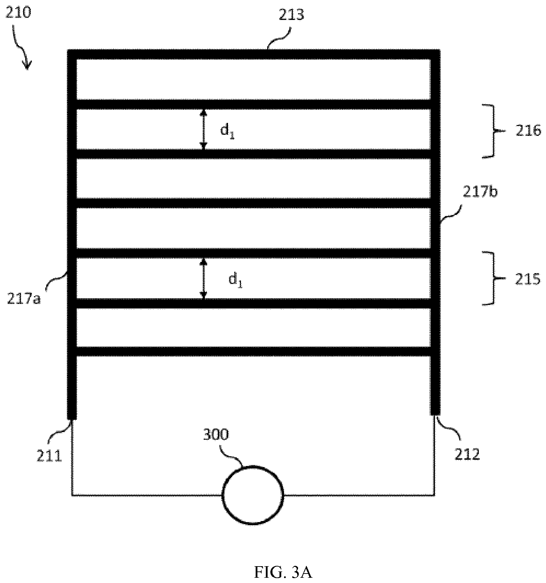

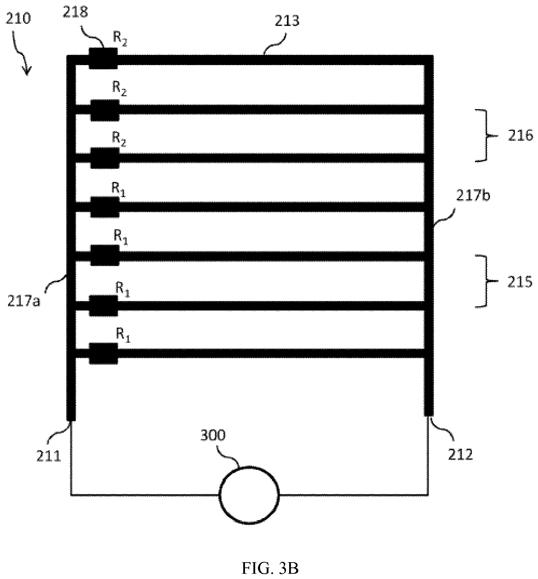

FIG. 3A and FIG. 3B illustrate exemplary examples of a side heater 210 having different heating sections adapted to produce different amounts of heat energy in response to an amount of power applied to the heater, but the assembling densities of the heating elements may be different for respective heating sections. In the first example illustrated in FIG. 3A, the side heater 210 is formed as a ladder similar to that in the example illustrated in FIG. 2C. The first side conductor 217a and the second side conductor 217b are connected to a power source 300 for applying a given amount of power to the side heater 210. In contrast to the example illustrated in FIG. 2c, the heating elements 213 may be disposed in the heating sections 215, 216 with the same distance d₁. Different materials of heating elements 213 of different heating sections 215, 216 produce different amounts of heat energy, wherein different materials have different resistivities, or cause that heating elements 213 of different heating sections 215, 216 to have different cross section area. However, as illustrated in FIG. 2C, heating elements 213 of different heating sections 215, 216 may be disposed at different distances to increase the difference in the introduced heat energy.

In a second example illustrated in FIG. 3B, the side heater 210 is formed similar to that in the example illustrated in FIG. 3A. However, each heating element 213 comprises an additional resistance part 218 which is serially connected with the remaining portion of the heating element 213, wherein resistance of additional resistance parts 218 is different from heating elements 213 of different heating sections 215, 216. For example, the additional resistance part 218 of each heating element 213 of the first heating section 215 has resistance R1, while the additional resistance part 218 of each heating element 213 of the second heating section 216 has resistance R2. The additional resistance part 218 does not make a contribution to the production of heat but causes the decrease of the power applied to the remaining portion of the heating element 213. Therefore, the remaining portion of one heating element 213 may be the same for all heating elements 213 in different heating sections 215, 216, but power which can be converted in the heating elements 213 may be different for different heating sections 215, 216.

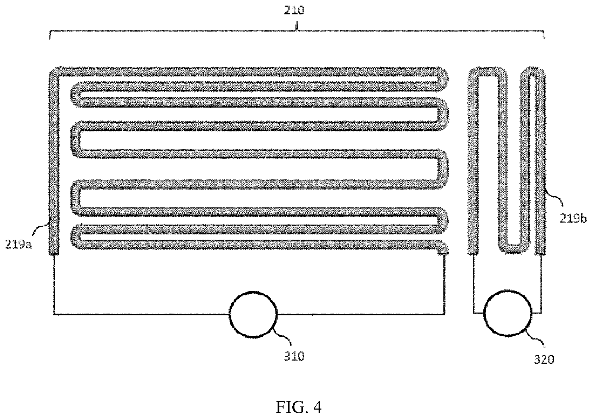

FIG. 4 illustrates an example of a side heater 210 having different portions 219a, 219b adapted to receive different amounts of applied power. The portions 219a and 219b both are formed in the same way, e.g., long conductors laid in a zigzag pattern. However, the portions 219a, 219b may also be formed as ladders similar to that illustrated in FIG. 2C or FIG. 3A. The heating elements may extend in the same or different directions, and the heating elements may be disposed in the same or different assembling densities. Moreover, if the heating elements have the same length and cross section, the heating elements may have the same or different resistances. In this example, a different feature lies in that different power applied to different portions 219a, 219b, because each portion 219a, 219b is connected to a separate power source. For example, the first portion 219a is connected to a first power source 310 capable of applying a first amount of power, while the second portion 219b is connected to a second power source 320 capable of applying a second amount of power. The amount of the applied power depends on the size and resistivity of the heating element, such that the difference in the amount of the applied power to different portions 219a, 219b per unit volume is within a range of 5%-20%, preferably about 10%, of a greater amount of applied power. Depending on the amount of power applied to different portions 219a, 219b and the resistance, different portions 219a, 219b may introduce different amounts of heat energy per unit area into the side surface of the crucible. Therefore, different portions 219a, 219b form different heating sections of the side heater 210 according to the present invention.

All types of different heating sections explained with reference to FIG. 2A to FIG. 4 relating to the side heater may be applied to the bottom heater in a similar way. When the heater is used in the heater device of the crucible, for crucible average temperature within a range of 600° C-700° C, a temperature difference between the lowest temperature and the highest temperature of different portions of the crucible may be smaller than or equal to 15K, i.e., excellent temperature uniformity in the entire volume of the crucible in the entire operating life of the crucible can be realized.

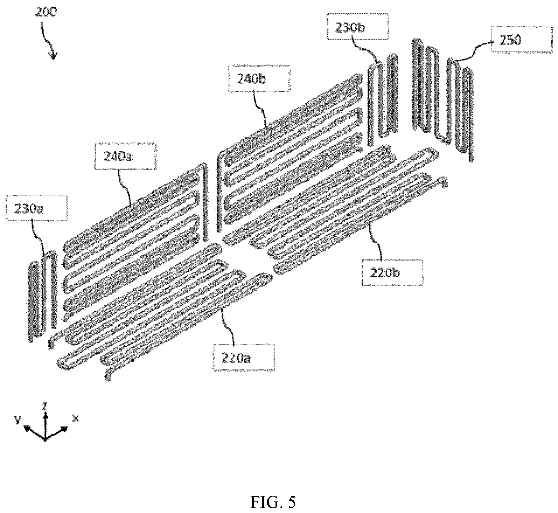

FIG. 5 illustrates a view of portions of a heater device 200 according to one specific design of the heater device. The heater device 200 is designed to be used for a crucible 100 which is a cuboid and has two long side surfaces and two short side surfaces, each long side surface extends in an x-z plane of an x-y-z coordinate system, and each short side surface extends in a y-z plane of the coordinate system. Besides, the crucible has a bottom surface which extends in an x-y plane of the coordinate system. The heat device 200 comprises: two corner heaters 230a, 230b; two middle heaters 240a, 240b, wherein the two middle heaters 240a, 240b are used for each long side surface of the crucible; one short side heater 250, wherein the one short side heater 250 is used for each short side surface of the crucible; and two bottom heaters 220a, 220b, wherein the two bottom heaters 220a, 220b are used for the bottom surface of the crucible. In other words, the heater device 200 totally comprises twelve heaters. Each heater of the heaters is formed as a long and continuous conductor, wherein each heater may be connected to a separate power source. Heating elements of the middle heaters 240a, 240b horizontally extend, i.e., extend in x direction, while heating elements of the corner heaters 230a, 230b and heating elements of the short side heater 250 vertically extend, i.e., extend in z direction. Heating elements of the bottom heaters 220a, 220b extend in x direction, i.e., extend from the middle of the bottom surface of the crucible to the corresponding short side surfaces of the crucible relative to the x direction. Each heater in the heaters may be connected to different power sources. However, some heaters such as two short side heaters may also be connected to the same power source. For a crucible having a length of about 1300mm (measured in the x direction), a width of about 280mm (measured in the y direction) and a height of about 290mm (measured in the z direction), electric power applied to the heater device 220 may be about 50kW on the whole. In different heaters, the power is distributed according to the sizes of the heaters and the heat energy per unit area which should be introduced by specific heaters into respective surfaces of the crucible.

Each middle heater 240a, 240b has at least three different heating sections, which have different assembling densities of heating elements. The first heating section of one of the middle heaters 240a, 240b is formed to be close to a top surface of the crucible and have a first assembling density. The second heating section of one of the middle heaters 240a, 240b is formed to be in a middle portion, relative to the z direction, of a long side surface of the crucible and have a second assembling density smaller than the first assembling density. The third heating section of one of the middle heaters 240a, 240b is formed to be close to the bottom surface of the crucible and have a third assembling density greater than the second assembling density. The third assembling density may be smaller than, equal to, or greater than the first assembling density.

Each corner heater 230a, 230b has at least two different heating sections which have different assembling densities of heating elements. The first heating section of one of the corner heaters 230a, 230b is formed to be close to the middle heater 240a or 240b and have a fourth assembling density. The second heating section of one of the corner heaters 230a, 230b is formed to be close to a corner edge of the crucible, i.e., close to adjacent short side surfaces of the crucible, and have a fifth assembling density greater than the fourth assembling density.

Each short side heater 250 has at least three different heating sections which have different assembling densities of heating elements. The first heating section of one of the short side heaters 250 is formed to be close to a first corner edge of the crucible, i.e., close to adjacent first long side surfaces of the crucible, and have a sixth assembling density. The second heating section of one of the short side heaters 250 is formed to be in a middle portion, relative to the y direction, of the short side surface of the crucible, and have a seventh assembling density smaller than the sixth assembling density. The third heating section of one of the short side heaters 250 is formed to be close to a second corner edge of the crucible, i.e., close to adjacent second long side surfaces of the crucible, and have an eighth assembling density greater than the seventh assembling density. The eighth assembling density may be smaller than, equal to, or greater than the sixth assembling density.

Each bottom heater 220a, 220b has at least three different heating sections which have different assembling densities of heating elements. The first heating section of one of the bottom heaters 220a, 220b is formed to be close to a first long side surface of the crucible and have a ninth assembling density. The second heating section of one of the bottom heaters 220a, 220b is formed to be in a middle portion, relative to the y direction, of the bottom surface of the crucible and have a tenth assembling density smaller than the ninth assembling density. The third heating section of one of the bottom heaters 220a, 220b is formed to be close to a second long side surface of the crucible and have an eleventh assembling density greater than the tenth assembling density. The eleventh assembling density may be smaller than, equal to, or greater than the ninth assembling density. In the illustrated embodiments, the heating elements of the bottom heaters 220a, 220b do not extend to adjacent short side surfaces of the crucible. However, in other embodiments, they may extend to the adjacent short side surfaces of the crucible.

The heater device 200 is symmetric with respect to the middle portions, relative to the x direction and the y direction, of the crucible.

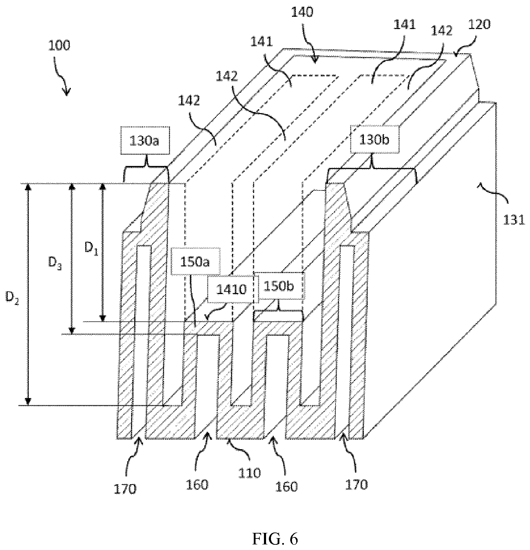

FIG. 6 illustrates a cross sectional view of a crucible 100 according to one embodiment of the present invention in a second aspect. The crucible 100 is a cuboid having a first or bottom surface 110, a second or top surface 120 and four side walls each having a side surface, wherein only two side walls 130a and 130b of the side walls and a side surface 131 of the side wall 130b can be seen in FIG. 6. The cross section extends from the side surface of the side wall 130a to the side surface 131 of the side wall 130b along the y direction. In the top surface 120 opposite to the bottom surface 110, a groove recess 140 is formed as an opening in the top surface 120. The groove recess 140 is used for receiving a material to be evaporated. The groove recess 140 has at least one first portion 141 and at least two second portions 142. In the embodiment illustrated in FIG. 6, the groove recess 140 has two first portions 141 and three second portions 142, and the portions are illustrated by dashed lines. The first portions 141 and the second portions 142 are lateral portions. All of the first portions 141 and the second portions 142 extend from the top surface 120 of the crucible 100 and together form a continuous opening in the top surface 120. The first portions 141 extend from the top surface 120 of the crucible 100 to a first depth D₁. The second portions 142 extend from the top surface 120 to a second depth D₂, wherein the second depth D₂ is greater than the first depth D₁. The two depths D₁ and D₂ both are measured from the top surface 120 along the z direction. In the embodiment illustrated in FIG. 6, the two first portions 141 both extend to the same first depth D₁, and all the second portions 142 extend to the same second depth D₂. However, different first portions 141 may extend to different first depths and different second portions 142 may extend to different second depths. Each first portion 141 has a bottom surface 1410.

The crucible 100 further comprises at least one crucible wall, and the at least one crucible wall extends from the bottom surface 110 of the crucible 100 to the direction of the top surface 120 such that the at least crucible wall protrudes into the groove recess 140. In the embodiment illustrated in FIG. 6, the crucible 100 has two crucible walls 150a, 150b. The crucible walls 150a and 150b extend to a depth D₁ such that a top surface of one of the crucible walls 150a, 150b is a bottom surface 1410 of one of the first portions 141 of the groove recess 140, i.e., each crucible wall 150a, 150b adjoins the bottom surface of one first portion 141. Besides, each crucible wall 150a, 150b separates two different second portions 142, and the second portions 142 adjoin specific first portions 141 corresponding to specific crucible walls 150a, 150b.

At least one bottom recess 160 is formed in at least one of the crucible walls 150a, 150b. In the embodiment illustrated in FIG. 6, at least one bottom recess 160 is formed in each crucible wall 150a, 150b. Each bottom recess 160 has an opening adjoining the bottom surface 110 of the crucible 100 and extending from the bottom surface 110 to a third depth D₃. The third depth D₃ is measured from the top surface 120 of the crucible 100 along the z direction, third depth D₃ is greater than the first depth D₁ and smaller than the second depth D₂. Each bottom recess 160 is adapted to receive a wall heater as a part of the heater device for heating the crucible 100 and a material to be evaporated and contained in the groove recess 140. The wall heater may be introduced from the bottom surface 110 of the crucible 100 into the bottom recess 160.

In the embodiment illustrated in FIG. 6, the crucible 100 additionally comprises side recesses 170, and the side recesses 170 are formed in the side walls 130a, 130b. Each of the side recess 170 has an opening adjoining the bottom surface 110 of the crucible 100 and extending to the direction of the top surface 120. However, the side recess 170 does not reach the top surface 120 and thus is closed on this side. The side recesses 170 are adapted to receive side heaters which are a part of the heater device for heating the crucible 100. However, the side recesses 170 may be not formed in the side walls 130a, 130b, and the side heaters of the heater device may be disposed on the side surface of each side wall 130a, 130b.

Some sizes of components of the crucible 100 will be given below. On the whole, the crucible 100 may has a length of about 1300mm measured in the x direction, a width of about 280mm measured in the y direction and a height of about 290 measured in the z direction. Each of the side walls 130a, 130b and the crucible walls 150a, 150b may have a width of 30mm-45mm measured in the y direction. Each bottom recess 160 and each side recess 170 may have such sizes in all directions such that the at least smallest thickness of the material of the crucible is kept at all points, wherein the smallest thickness of the material of the crucible is adapted to guarantee the physical stability of the crucible body. For example, the smallest thickness of the material of the crucible in the crucible walls 150a, 150b and the smallest thickness of the material of the crucible that separates the second portions 142 from the bottom recess 160 of the groove recess 140 are within a range of 10mm-15mm for the crucible 100 made of graphite. Therefore, each of the bottom recess 160 and the side recesses 170 may have a width of 10mm-20mm, preferably about 10mm measured in the y direction. This width must be enough for receiving the heaters in respective recesses. The second depth D₂ is within a range of 240mm-270mm. The first depth D₁ is within a range of one-third of D₂ to two-third of D₂, and preferably is about half of D₂, i.e., D₁ is within a range of 80mm-180mm, and preferably about 120mm-135mm. The third depth D₃ depends on the first depth D₁ and is equal to a sum of D1 and the thickness of the material of the crucible between the bottom surface 1410 of the first portions 141 of the groove recess 140 and the corresponding bottom recess 160 in adjoining crucible walls 150a, 150b. Therefore, the third depth D3 is within a range of 95mm-195mm, and preferably about 130mm-150mm.

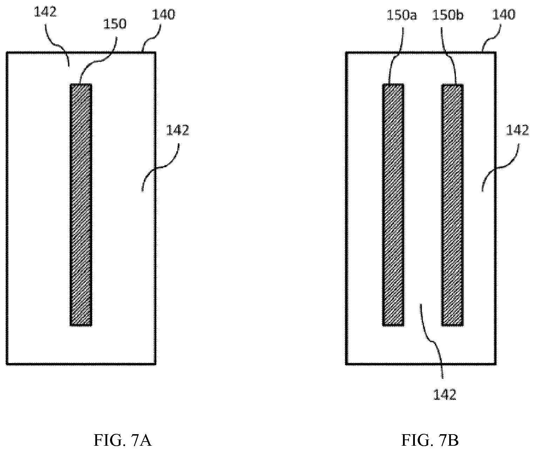

FIG. 7A to FIG. 7D illustrate planar views of crucible walls 150 of a crucible 100 according to exemplary designs of the present invention. In the drawings, only the groove recess 140 and the crucible wall 150 are illustrated and the side walls of the crucibles are not illustrated.

In the example illustrated in FIG. 7A, only one crucible wall 150 is formed in the groove recess 140. The crucible wall 150 is separated from all side walls of the crucible through the second portion 142 of the groove recess 140. The crucible wall 150 extends along the long side direction of the crucible.

In the example illustrated in FIG. 7B, two crucible walls 150a, 150b are formed in the groove recess 140. Therefore, FIG. 7B illustrates a planar view of the crucible 100 illustrated in FIG. 6, wherein only the groove recess 140 and the crucible walls 150a, 150b are illustrated. The crucible walls 150a, 150b extend along the long side direction of the crucible and are in parallel with each other. The crucible walls 150a, 150b are separated from each other through the second portion 142 of the groove recess 140. The crucible walls 150a, 150b do not adjoin the side walls of the crucible. The crucible walls 150a, 150b may have the same size or different sizes.

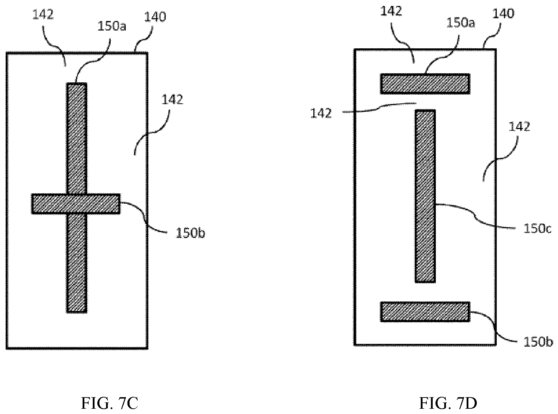

In the example illustrated in FIG. 7C, similarly two crucible walls 150a, 150b are formed in the groove recess 140. However, the crucible wall 150a extends along the long side direction of the crucible, while the crucible wall 150b extends along the short side direction of the crucible. The crucible walls 150a, 150b are intersected with each other in an orthogonal way. However, at least one of the crucible walls may extend to the direction of the other such that the crucible walls are intersected with each other at another angle.

In the example illustrated in FIG. 7D, three crucible walls 150a, 150b, 150c are formed in the groove recess 140. The crucible walls 150a, 150b extend along the short side direction of the crucible, while the crucible wall 150c extends along the long side direction of the crucible. The crucible walls 150a, 150b, 150c are separated from one another through the second portion 142 of the groove recess 140, are separated from the side walls of the crucible, and are not intersected with one another or do not adjoin one another.

The embodiments of the present invention described in the above-mentioned description are instances given as examples and the present invention is absolutely not limited thereto. Any modification, variation, equivalent configuration and combination made to the embodiments shall be considered as included in the scope of the present invention.

List of component reference numbers
- 10: Crucible
- 11: Bottom surface
- 12: Top surface
- 13: Side surface
- 14: Groove recess
- 100: Crucible
- 110: First or bottom surface
- 120: Second or top surface
- 130a, b: Side wall
- 140: Groove recess
- 141: First portion of groove recess
- 142: Second portion of groove recess
- 1410: Bottom surface of first portion
- 150, 150a-c: Crucible wall
- 160: Bottom recess
- 170: Side recess
- 200: Heater device
- 210: Side heater
- 211: First end portion of conductor
- 212: Second end portion of conductor
- 213: Heating element
- 214: Bending portion
- 215: First heating section
- 216: Second heating section
- 217a: First side conductor
- 217b: Second side conductor
- 218: Additional resistance part
- 219a: First portion
- 219b: Second portion
- 220, 220a, 220b: Bottom heater
- 230a, 230b: Corner heater
- 240a, 240b: Middle heater
- 250: Short side heater
- 300: Power source
- 310: First power source
- 320: Second power source
- d₁, d₂: Distance between heating elements
- R₁, R₂: Resistance of additional resistance part
- D₁-D₃: First depth to third depth

## Claims

1. A heater device for heating a crucible, the crucible having a bottom surface and at least one side surface, the heater device comprising: at least one resistance bottom heater used for heating the bottom surface of the crucible, and at least one resistance side heater used for heating each side surface of the crucible,
wherein at least one heater of the heaters comprises different heating sections and the different sections are adapted to introduce heat energy with different amounts into different portions of each surface of the crucible.

2. The heater device according to claim 1, wherein the different heating sections are formed by resistance heating elements in different assembling densities per unit area.

3. The heater device according to claim 1 or 2, wherein the different heating sections are formed by different resistance heating elements and the different resistance heating elements are adapted to produce different amounts of heat energy in response to power applied from a power source to the heater.

4. The heater device according to any one of the preceding claims, wherein the different heating sections are formed by different portions of the heater, the different portions of the heater are adapted to receive power applied from different power sources with different amounts, wherein a specific heating section is connected to a specific power source.

5. The heater device according to any one of the preceding claims, wherein the heat energy introduced into a first portion of the side surface of the crucible is higher than the heat energy introduced into a second portion of the same side surface, and the first portion has a distance to the bottom surface of the crucible greater than the second portion.

6. The heater device according to claim 5, wherein the heat energy introduced into a third portion of the side surface of the crucible is higher than the heat energy introduced into the second portion of the same side surface, and the third portion has a distance to the bottom surface of the crucible smaller than the second portion.

7. The heater device according to any one of the preceding claims, wherein the crucible has at least three side surfaces, and wherein the heat energy introduced into a fourth portion of the side surface of the crucible is higher than the heat energy introduced into a fifth portion of the same side surface, and the fourth portion has a distance to planes of specific adjacent side surfaces of the crucible smaller than the second portion.

8. The heater device according to any one of the preceding claims, wherein,
- the heater device is adapted to a rectangular crucible, the crucible has two long side surfaces and two short side surfaces,
- each heater in the heater device is formed as a long electric conductor, and the electric conductor has high resistivity and is configured in a zigzag pattern,
- two corner heaters and at least one middle heater are disposed on each long side surface, the two corner heaters are disposed at an edge of the corresponding side surface and the at least one middle heater is disposed in the middle of the two corner heaters,
- a conductor of the middle heater is disposed to horizontally zigzag, and conductors of the corner heaters are disposed to vertically zigzag,
- a conductor of the at least one bottom heater is disposed to zigzag along a long extension portion of the crucible, and
- each heater has different heating sections formed by conductors in different assembling densities,
the heating sections having higher assembling densities are formed at portions of each heater having a distance to the edge of each surface smaller than portions of each corner heater and the bottom heater having a greater distance to each edge of the surface of the crucible; and
the heating sections having higher assembling densities are formed at portions of each middle heater having a distance to a top surface of the crucible or the bottom surface of the crucible smaller than other portions of each middle heater.

9. A method for operating a heater device, the heater device being used for heating a crucible, the crucible having a bottom surface and at least one side surface, the heater device comprising: at least one resistance bottom heater used for heating a bottom of the crucible and at least one resistance side heater used for heating each side surface of the crucible, wherein at least one heater of the heaters comprises different heating sections and the different heating sections are adapted to introduce different amounts of heat into different portions of each surface,
the method comprising: connecting at least two different heating sections of at least one of the at least one bottom heater and one of the at least one side heater and/or specific heater to different power sources, and
applying different amounts of power to the at least two different heating sections.

10. The method according to claim 9, wherein the power applied to the at least one of the at least one bottom heater and one of the at least one side heater and/or the power applied to the at least two different heating sections change with time in different ways.

11. A crucible for heating a material to be evaporated or sublimated, comprising:
- at least one groove recess, the at least one groove recess being adapted to receive the material to be evaporated or sublimated, the groove recess being formed in a first surface of the crucible and having at least one first portion and at least two second portions, the first portion extending to a first depth measured from the first surface of the crucible and having a bottom surface, the bottom surface being formed at a distance to the first depth of the first surface of the crucible, the second portions extending to a second depth measured from the first surface of the crucible, and the second depth being greater than the first depth,
- at least one crucible wall, the at least one crucible wall extending from a second surface opposite to the first surface of the crucible to a bottom surface of one first portion of the at least one first portion of the groove recess, the crucible wall adjoining and laterally separating the two second portions of the groove recess, and the two second portions adjoining the first portion of the groove recess, and
- at least one bottom recess, the at least one bottom recess being formed inside the crucible wall, the bottom recess having an opening adjoining the second surface of the crucible and extending to a third depth from the second surface of the crucible to the first surface of the crucible, the third depth being greater than the first depth and smaller than the second depth.

12. The crucible according to claim 11, wherein the crucible wall is spaced apart from all side walls of the crucible through the second portions of the groove recess.

13. The crucible according to claim 11 or 12, wherein the crucible comprises more than one crucible walls, wherein at least two crucible walls extend in parallel with each other.

14. The crucible according to claim 11 or 13, wherein the crucible comprises more than one crucible walls, wherein at least two crucible walls are intersected with each other.

15. The crucible according to claim 11 or 14, wherein the crucible comprises more than one crucible walls, wherein at least two crucible walls extend in directions which are orthogonal with each other and are spaced apart from each other through one second portion of the at least two second portions of the groove recess.

16. A system for evaporating or sublimating a material, the system comprising the crucible according to any one of claims 11-15 and a heater device for heating the crucible, wherein the heater device comprises at least one wall heater disposed in at least one bottom recess of the crucible.

17. The system according to claim 16, wherein the heater device further comprises a heater device according to any one of claims 1-8.

18. The system according to claim 16 or 17, wherein the at least wall heater comprises different heating sections and the different heating sections are adapted to introduce different amounts of heat energy into different portions of the crucible wall in which the wall heater is disposed.
